# EUROPEAN PATENT APPLICATION

(11) **EP 4 765 648 A1**
(43) Date of publication of application: **24.06.2026**
(21) Application number: 24221162.1
(22) Date of filing: 18.12.2024
(51) Int. Cl.: H03M 7/30, G01C 21/32, G01C 21/00

(54) **DIFFERENTIAL COMPRESSION OF STRUCTURED MAP DATA**

(71) Applicant: TomTom Global Content B.V., 1011 AC Amsterdam (NL)
(72) Inventor: DIRKSE, Philippe, Amsterdam (NL)
(74) Representative: Dehns

(57) **Abstract**

A method of differentially compressing structured map data for regenerating a target-map bitstream from a source-map bitstream is disclosed. The structure of source data entities within the source map data is used to determine (11) a set of source bit sequences present within the source-map bitstream, each encoding one or more source data entities. The structure of target data entities within the target map data is used (11) to determine a set, and associated structure, of target bit sequences present within the target-map bitstream, each encoding one or more target data entities. The structure of the target bit sequences is used (12) to identify a first bit sequence in the set of target bit sequences that is also in the set of source bit sequences. Difference data is generated (13) that includes a copy instruction for copying at least the first bit sequence from the source-map bitstream when regenerating the target-map bitstream.

## Description

### TECHNICAL FIELD

This disclosure relates to methods, system and software for differentially compressing structured map data.

### BACKGROUND

Map data has many uses. For example, in the automotive industry, map data can be used for activities such as route planning, guiding drivers through a road network (e.g. in a satellite navigation system), for vehicle safety (e.g. when used within an Advanced Driver Assistance System), and for controlling the motion and behaviour of autonomous vehicles, such as self-driving cars.

It can be desirable to update map data so that it remains current. Map updates may be delivered from a map server (e.g. at a datacentre) to remote clients (e.g. within vehicles) over a communications network. The network may include a cellular telecommunications network. Map updates may be large and sending them over such networks can be costly.

NDS.Live is a map data standard that supports the use of differential compression (also referred to as delta encoding) to reduce the size of tile updates sent to a client application. The NDS.Live data is first serialized and then differential compression is applied to produce a description (also referred to difference data) of the difference between two sets of data-in this instance, between (older) source map data and (updated) target map data. To create this difference data, an algorithm searches for matching ranges between source data and target data that can be reused when recreating the target. The resulting difference data consists of a sequence of copy instructions (where the range in the source to use to reconstruct the next part of the target) and insert instructions (each containing a buffer that holds new data not present in the source to add to the target). By applying these operations to the source map data, a client that receives the difference data can regenerate the target map data. The difference data is typically much more compact than the target map data, and so requires less network bandwidth to communicate to the clients.

However, difference data generated from map data, such as serialized NDS.Live map data, using conventional approaches can still be quite large. It would be desirable for this to be reduced further. Embodiments of the present disclosure seek to provide methods for improved differential compression of map data.

### SUMMARY

From a first aspect, the disclosure provides a method of differentially compressing structured map data to generate difference data for regenerating a target-map bitstream from a source-map bitstream, wherein the source-map bitstream encodes structured source map data that comprises a structure of source data entities, and wherein the target-map bitstream encodes structured target map data that comprises a structure of target data entities, the method comprising:
using the structure of the source data entities within the source map data to determine a set of source bit sequences present within the source-map bitstream, wherein each of the source bit sequences of the set encodes one or more of the source data entities;
using the structure of the target data entities within the target map data to determine a set of target bit sequences present within the target-map bitstream, wherein each of the target bit sequences of the set encodes one or more of the target data entities, and to determine an associated structure of the set of target bit sequences;
using the structure of the set of target bit sequences to identify a first bit sequence in the set of target bit sequences that is also present within the set of source bit sequences; and
generating difference data comprising insert instructions and copy instructions for regenerating the target-map bitstream from the source-map bitstream, wherein the copy instructions include a copy instruction for copying at least the first bit sequence from the source-map bitstream when regenerating the target-map bitstream.

From a further aspect, the disclosure provides a computer software comprising instructions which, when executed on a processing system, cause the processing system to perform a method as disclosed herein. The computer software may be stored on a non-transitory computer-readable storage medium, such as a solid-state or magnetic or optical storage medium.

From a further aspect, the disclosure provides a processing system configured to perform a method as disclosed herein. The processing system may comprise one or more processors and a memory storing computer software for execution by the one or more processors for carrying out steps of the method. The processing system may be at a single location or may be distributed. It may provide a map server and may be configured to communicate the difference data to a client system. The client system may be within a vehicle.

Thus it will be seen that, in accordance with embodiments of the disclosure, the structure of the source and target map data is harnessed when applying the differential compression. This may lead to greater compression ratios, especially when applied to certain types of map data, as explained in more detail below. In particular, the inventors have realised that conventional differential compression (e.g. using bsdiff, vcdiff or fossil) can perform poorly on serialized data that is not byte-aligned. Embodiments of the present disclosure, by contrast, may operate on bit sequences that do not need to be byte-aligned, and so can provide improved compression in such situations. However, the same methods may also be beneficially applied to many types of map data, whether or not it is byte-aligned.

The method may comprise using the structure of the set of target bit sequences to identify a plurality of bit sequences in the set of target bit sequences that are also present within the set of source bit sequences, and generating difference data respective copy instructions for copying each respective bit sequence of the plurality of bit sequences from the source-map bitstream when regenerating the target-map bitstream.

The identified first bit sequence may be a longest bit sequence that is present within both sets of bit sequences. The copy instruction for copying at least the first bit sequence may instruct copying exactly the identified first bit sequence from the source-map bitstream when regenerating the target-map bitstream.

The method may comprise using the structure of the set of target bit sequences to identify a second bit sequence in the set of target bit sequences that is also present within the set of source bit sequences. It may comprise determining that the second bit sequence is contiguous with the first bit sequence in the source-map bitstream, and, in response, generating the difference data such that the copy instruction for copying at least the first bit sequence instructs copying a bit sequence that is or comprises a concatenation of the first bit sequence and the second bit sequence.

The method may further comprise calculating hashes of all of the source bit sequences. The hashes may be stored in an electronic memory (e.g. of the processing system) as a searchable set of source hashes-e.g. as a list of hashes. The method may further comprise calculating hashes of some or all of the target bit sequences, and identifying a bit sequence in the set of target bit sequences as also being present within the set of source bit sequences by calculating or retrieving a hash of the bit sequence and searching the set of source hashes for the hash of the bit sequence. In some embodiments, when a match is found, the method may further comprise comparing the target bit sequence with the source bit sequence to check that the bit sequences are identical. This may be useful in embodiments where there is a realistic possibility of hash collisions.

The target-map bitstream may be stored in a target buffer, e.g. in an electronic memory of the processing system. The source-map bitstream may be stored in a source buffer, e.g. in an electronic memory of the processing system.

The structure of the data entities within the source map data may comprise a hierarchy of data entities. The structure of the data entities within the target map data may comprise a hierarchy of data entities. The data entities within the source map data and the target map data may comprise primitives and/or objects and/or arrays. The data entities may comprise respective array elements, and may additionally comprise one or more data objects or primitives that are not array elements. Each hierarchy of data entities may depend at least partly based upon array membership, whereby a data entity that is a member of an array is a child of the data entity that is the array.

The set of target bit sequences and the associated structure of the set of target bit sequences may be determined partly or wholly upon array membership within the structure of the target data entities. The set of source bit sequences may be determined partly or wholly upon array membership within the structure of the source data entities.

The structure of the set of target bit sequences present within the target-map bitstream may comprise a hierarchy of target bit sequences, wherein each child sequence in the hierarchy of target bit sequences has a parent sequence of which the child sequence is a subsequence. Determining an associated structure of the set of target bit sequences may comprise storing data representative of the structure, which may be stored together with or separately from the target-map bitstream (e.g. in a different region of memory); the data may comprise a set of pointers or addresses to the respective target bit sequences (e.g. to a target buffer that stores the target-map bitstream). The method may comprise traversing the hierarchy of target bit sequences to identify one or more bit sequences in the hierarchy of target bit sequences that are also present within the set of source bit sequences.

The hierarchy of target bit sequences may be a tree. It may be represented by a tree of nodes stored in an electronic memory (e.g. of the processing system). Each node may correspond to a respective data entity of the target map data. Each node may comprise data encoding a first bit position (e.g. within a target buffer) and a length or last bit position of a respective target bit sequence. Each node may encode additional data which may include a hash of the target bit sequence. Traversing the hierarchy of target bit sequences may comprise traversing the tree of nodes.

Using the structure of the source data entities within the source map data to determine a set of source bit sequences present within the source-map bitstream may further comprise determining an associated structure of the set of source bit sequences. Determining an associated structure of the set of source bit sequences may comprise storing data representative of the structure, which may be stored together with or separately from the source-map bitstream (e.g. in a different region of memory); the data may comprise a set of pointers or addresses to the source bit sequences (e.g. to a source buffer that stores the source-map bitstream). The structure may be a hierarchy of source bit sequences wherein each child sequence in the hierarchy of source bit sequences has a parent sequence of which the child sequence is a subsequence. In some embodiments, the structure or hierarchy of source bit sequences may be represented by a tree of nodes stored in an electronic memory (e.g. of the processing system). Each node may comprise data encoding a first bit position (e.g. within a source buffer) and a length or last bit position of a respective source bit sequence. Each node may encode additional data which may include a hash of the source bit sequence. However, in other embodiments, the structure of source data entities within the source map data may be used to determine a set of source bit sequences, but not be used to determine any associated structure for the set-e.g. the set may simply be represented by an ordered or unordered list of entries, such as a lookup table, stored in an electronic memory. Each entry may comprise data encoding a first bit position (e.g. within a source buffer) and a length or last bit position of a respective source bit sequence. Each node may encode additional data which may include a hash of the source bit sequence.

The source-map bitstream may be a root of a structure (e.g. hierarchy) of source bit sequences. The target-map bitstream may be a root of the structure (e.g. hierarchy) of target bit sequences. The structure (e.g. hierarchy) of target bit sequences may comprise at least two levels of subsequences below a root level.

The hierarchy of target bit sequences may be a tree comprising a plurality of branches (i.e. parent-child relationships). Traversing the hierarchy of target bit sequences may comprise performing a depth-first traversal wherein, for each branch that is descended, the descending ceases if a bit sequence represented by a child node on the branch is identified as being also present within the set of source bit sequences. The method may comprise, in response to such a ceasing, determining whether a sibling node of the child node represents a further bit sequence that is contiguous with the identified bit sequence in the source-map bitstream, and, when this is so, generating the difference data to include a copy instruction that instructs copying a bit sequence that is or comprises a concatenation of the bit sequence and the further bit sequence.

In some embodiments, at least one of the source bit sequences is not byte-aligned within the source-map bitstream data and/or at least one of the target bit sequences is not byte-aligned within the target-map bitstream data.

Each of the copy instructions in the difference data may comprise (i.e. encode) a bit position and a bit length. In some embodiments, the bit positions are delta encoded. Additionally or alternatively, in some embodiments, the bit positions and bit lengths are encoded as variable-width integers.

The source and target map data may be NDS.Live map data. They may be respective NDS.Live layers or map tiles. The source-map and target-map bitstreams may be serialized NDS.Live map data-e.g. different versions of a same type of NDS.Live layer.

Features of any aspect or embodiment described herein may, wherever appropriate, be applied to any other aspect or embodiment described herein. Where reference is made to different embodiments or sets of embodiments, it should be understood that these are not necessarily distinct but may overlap.

### BRIEF DESCRIPTION OF THE DRAWINGS

Certain embodiments of the disclosure will now be described, by way of example only, with reference to the accompanying drawings, in which:
Figure 1 is a schematic drawing of a server-client system that implements an embodiment;
Figure 2 is a diagram of a portion of source data and target data illustrating a byte alignment challenge;
Figure 3 is a flow chart of a process for generating difference data performed by the server;
Figure 4 is a tree diagram of source bit sequences present within a source-map bitstream;
Figure 5 is a tree diagram of target bit sequences present within a target-map bitstream;
Figure 6 is a diagram showing a structure of source data entities within a portion of source map data.

### DETAILED DESCRIPTION OF EMBODIMENTS

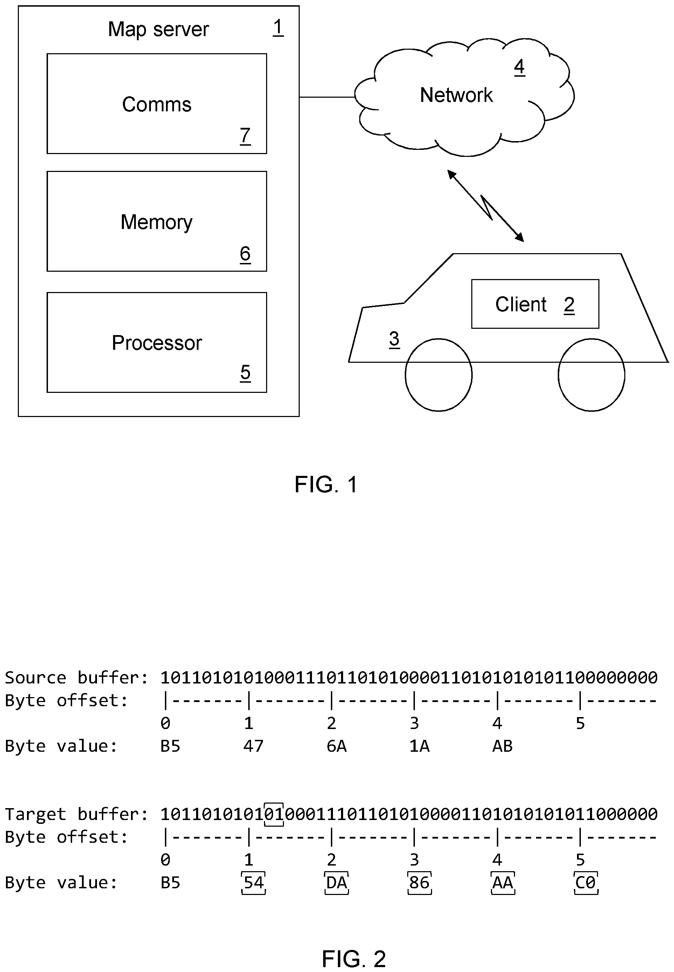

Figure 1 shows a map server 1 that is configured to send structured map data to a client processing system 2 on a vehicle 3. The vehicle 3 may be an autonomous vehicle or it may have a driver. It may be a car or truck or any other road vehicle, or marine vehicle or aircraft. The client 2 may use the map data for route planning and/or vehicle safety and/or guiding a driver and/or controlling the motion or other behaviour of the vehicle 3. The client 2 may receive updated map data at intervals from the map update server 1 over a communications network 4, which may include the Internet and/or a cellular telecommunications network. The map data may be sent over one or more wireless and/or wired and/or optical links.

The map server 1 comprises at least one processor 5, a memory 6 storing software for execution by the processor 5. The memory may comprise volatile and/or non-volatile portions. It may also store data, such as structured map data, as well as temporary data as the software executes. A communications module 7 allows the map server 1 to communicate with the network 4. implements one or more methods disclosed herein for differentially compressing structured map data before transmission to the vehicle 3. In this way, the volume of data is reduced, resulting in more efficient transmission to the vehicle 3. This can reduce the time and/or cost of sending the map data.

Instead of sending updates as a complete new set of structured map data, the map server 1 uses differential compression to send difference data that enables the client 2 to reconstruct the new updated map data from existing map data stored in a memory of the client 2. Specifically, the difference data enables target map data to be generated from source map data. The map server 1 uses the target map data and the source map data to generate the difference data. The client 2 then uses the source map data and the difference data to generate the target map data.

The difference data contains insert instructions and copy instructions. Copy instructions tell the client 2 to copy a specified length of data from a specified position in the source map data to a specified position within the target map data. Insert instructions are accompanied by encoded data and tell the client 2 to insert the data at a specified position within the target map data. Data in the source map data that is not required by the target map data need not be mentioned in the difference data and will thus be omitted by the client 2 when generating the target map data.

At least for some types of map data, the source and target map data may not be byte aligned. For example, the map data may, in some embodiments, conform to a current or future version of the NDS.Live specification. NDS.Live uses zserio for serializing map data into a bit stream that is not byte-aligned. This makes it ill-suited for byte-aligned differential encoding as just a small change between the source and target map data can result in many bytes being different.

Figure 2 illustrates this problem. It shows a source buffer and a target buffer that contain identical bitstreams except that the target buffer has two bits "01" inserted between the tenth and eleventh bits of the source buffer. Although the target buffer differs only at this one position, every byte apart from the first byte "B5" is changed as a consequence of the insertion. For example, the fourth byte in the source buffer is "1A" but the fourth byte in the target buffer is "86". If using byte-aligned differential compression, the difference data would copy the first byte but then insert all the remaining bytes, and hence provide little or no compression.

Although the NDS.Live extensively applies aligning to byte boundaries in its internal data structures (e.g., in the AttributeMap) this is not used everywhere and, even within the byte-aligned data, bit shifts can occur. Also, excessive byte alignment of data may negate the benefits of serializing the data into a bit stream.

To improve on this, the map server 1 uses a novel differential compression method that does not assume byte-alignment of the source and target map data, which may be serialized bit streams. Instead of searching for overlap at the byte level, the map server 1 searches at the bit level. In the example of Figure 2, this would detect that the entire set of bits following the two newly inserted bits can be copied from the source, and hence result in much more compact difference data for transmission to the client 2.

A challenge, however, is how to efficiently detect ranges that are present in both the source data and target data. A brute-force approach, searching for overlapping bit ranges by comparing every range in the target, of every length, with every range in the source, is too inefficient in practice as the search space is too big for anything larger than trivial amounts of data. In practice, the serialized source and target data for an entire map may each contain hundreds or thousands of megabytes. Byte-aligned compression algorithm rely on sampling the source buffer and looking for matches using a sliding window on the target buffer, which reduces the search space to a feasible size. However, this approach cannot be efficiently applied to bit ranges.

Instead, the map server 1 reduces the search space by making use of the underlying semantics of structured map data that is represented by the bitstreams stored in the source and target buffers. By pre-processing the source and target map data, a respective hierarchical tree structure is created for the source and for the target, and subtree matching is used to find matching bit ranges in the source and target buffers.

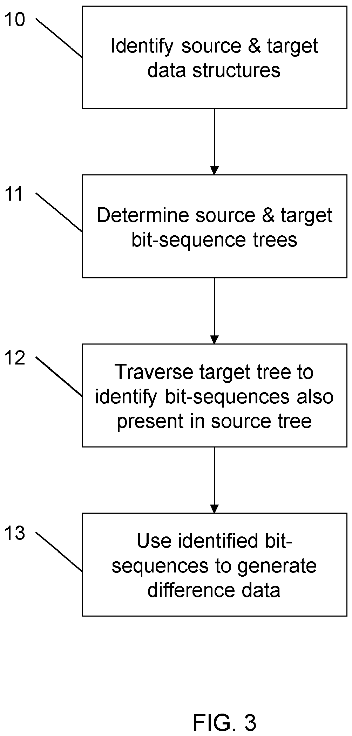

Figure 3 provides an overview of the method, which is described in more detail below.

In a first step 10, software executing on the processor 5 of the map server 1 identifies data structures of data entities within the source and target map data. It may do this by processing the map data before the map data is serialized into respective bitstreams, or while it is being serialized, or after it has been serialized, or it may receive meta data representing the structure of one or both sets of map data from an external source.

In a second step 11, the map server 1 uses the structure of the source map data to determine a source set of bit sequences, each present within the serialized source-map bitstream, wherein each of the bit sequences in the set encodes one or more data entities of the source map data. It also uses the structure of the target map data to determine a target structure of bit sequences, each present within the serialized source-map bitstream, wherein each of the bit sequences in the structure encodes one or more data entities of the target map data. Data representing the source set and the target structure may be stored in the memory 6. The target set of bit sequences represents at least a part of the structure of the target map data-e.g. as a target tree. The source set of bit sequences may be an unordered or ordered list, but, in some embodiments, it represents at least a part of the structure of the source map data-e.g. as a source tree.

In a third step 12, the map server 1 uses the structure of target bit sequences to identify bit sequences in the structure of target bit sequences that are also present within the set of source bit sequences. In this example, it does so by systematically traversing the target tree.

In a fourth step 13, the map server 1 generates difference data comprising insert instructions and copy instructions for the client 2 (and potentially other clients also) to regenerate the target-map bitstream from the source-map bitstream, wherein the copy instructions include copy instructions for copying each of the identified bit sequences from the source-map bitstream when regenerating the target-map bitstream (i.e. for copying the identified bit sequences from a source buffer into a target buffer in a memory of the client 2 in order to create a copy of the target-map bitstream within the target buffer).

The map server 1 can then store the difference data in the memory 6, before sending it over the network 4 to one or more clients 2 that store copies of the source-map bitstream, in order to enable the clients 2 to update their map data. Upon receiving the difference data, the client 2 will apply the insert and copy instructions to a copy of the source-map bitstream for generating a copy of the target-map bitstream within its memory. The client 2 can then deserialize the bitstream and replace its former map data (the source map data) with the new target map data.

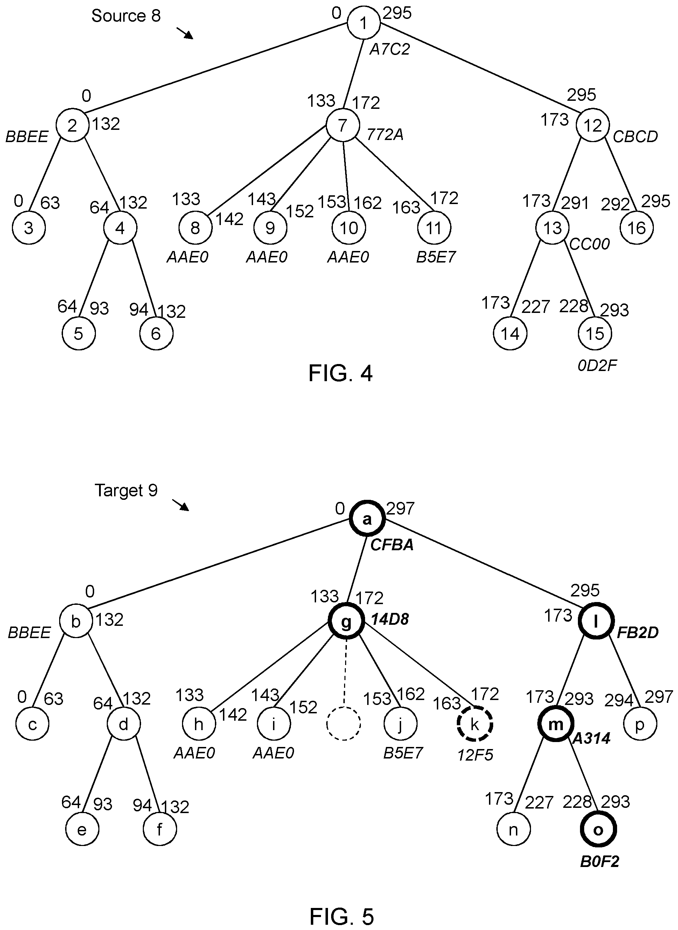

Figure 4 shows an example of a source tree 8 of bit sequences, present within exemplary serialized source map data (e.g. an NDS.Live layer), which have been determined in dependence upon the structure of data entities within the source map data.

Figure 5 shows an example of a target tree 9 of bit sequences, present within exemplary serialized target map data (e.g. an NDS.Live layer), which have been determined in dependence upon the structure of data entities within the target map data.

For each of the source and target map data, the map data may comprise one or more arrays (e.g. present within a particular NDS.Live layer), each of which may contain further arrays and/or data objects and/or primitive data types such as ints, floats and strings. The map server 1 may use the array structure of the map data to generate the corresponding tree of bit sequences, with each array in the map data being represented by a respective node of the tree, and with array membership corresponding to a parent-child relationship within the tree. Further nodes may be included to represent objects and/or primitive data types that appear in the bitstream but that are not contained within arrays.

In some embodiments, the map server 1 constructs each tree 8, 9 using a modified zserio serializer module that generates a node in the tree for each array element that it encounters in the respective map data as it progressively serializes the map data.

The root node 1 of the source tree 8 represents the entire source-map bitstream (e.g. the serialization of one whole NDS.Live layer), while the root node a of the target tree 9 represents the entire target-map bitstream. Underneath these root nodes 1, a, are child nodes representing respective subsequences of the source-map and target-map bitstreams. The pair of decimal numbers alongside each node indicates the positions of the first and last bits of the sequence within the corresponding bitstream (referred to herein as first_bit_position and first_bit_position, respectively).

The trees 8, 9 have the following properties:
- each node has a first bit position and a last bit position that define a continuous range of bits from a respective source-map bitstream buffer or a target-map bitstream buffer
- each node represents a data entity that is a likely candidate for appearing in both the source buffer and the target buffer
- when traversing the tree depth first, the following rules apply:
   a. first_bit_position_{first_child} == first_bit_positionₚₐᵣₑₙₜ
   b. last_bit_position_{last_child} == last_bit_positionₚₐᵣₑₙₜ
   c. last_bit_position_{sibling_x} + 1 == first_bit_position_{sibling_x+1}

The number or letters within the node of the trees 8, 9 denote an order in which the nodes are traversed when searching for matching sequences, as explained below.

The italicised hexadecimal numbers alongside some of the nodes are cryptographic hashes of the respective sequences, which may be used in some embodiments to improve the efficiency of searching for matches. These may be determined using an appropriate hash algorithm, e.g. MD5. The hashes may be of sufficient length that, for the type of map data that is being compressed, the possibility of hash collisions is sufficiently unlikely that it can be discounted.

The nodes and hashes in bold type in the target tree 9 indicate nodes whose data has been changed compared with the source tree 8. The empty dashed node, between nodes i & j, indicates where a node has been deleted, while the bold dashed node k corresponds to new data (i.e. which must be encoded for insertion within the difference data).

The following algorithm is then performed by software executing on the map server 1 to find the longest ranges in the source buffer that are also present in the target buffer (i.e. that the client 2 can later copy from its source buffer to its target buffer when generating the target bitstream):

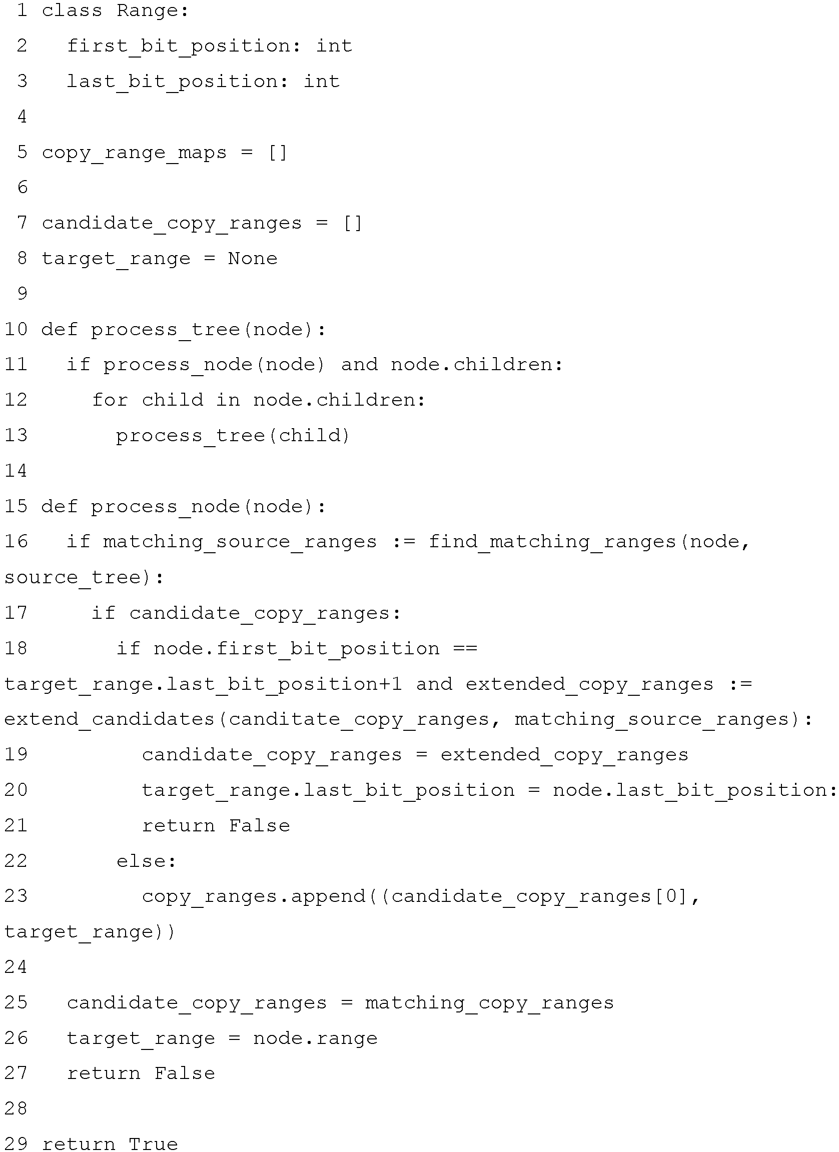

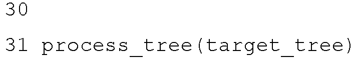

This algorithm traverses the relevant nodes in the target tree 9 (using the process_tree function) and looks for matching nodes in the source tree 8 (function find_matching_ranges). Some implementations calculate a hash value for each node in the source and target trees 8, 9 and prepare a lookup table of hashes of the source-tree nodes in the memory 6 for this purpose. In some embodiments, this table may represent the set of source bit sequences, e.g. comprising data encoding each hash and also encoding a start position and length (or end position) of the corresponding bit sequence in the source buffer. If matches are found, the function returns the range in the source buffer for each. If the hashes are insufficiently long as to be assumed collision free, then a further step of comparing the respective bit sequences may be performed when two hashes match, to ensure the underlying bit sequences also match.

Thus, the map server 1 may calculate hashes of all of the source bit sequences; store the hashes in an electronic memory 6 as a searchable set of source hashes; calculate hashes of some or all of the target bit sequences; and identify one or more bit sequences in the structure of target bit sequences as also being present within the set of source bit sequences by calculating or retrieving a hash of the respective bit sequence and searching the set of source hashes for the hash of the bit sequence.

The algorithm performs a depth-first search over the target tree 9, looking for the longest range in the source buffer that can be copied to the target buffer, which may be longer than just the one matching node. For this it keeps a list of candidate_copy_ranges, containing one or more ranges in the source buffer, that match the target_range. If there exist no more matches in the source for the current node, or there is a gap between the current node first_bit_position and the target_range.last_bit_position, the first candidate range is taken and added to the copy_ranges_map list.

If a matching_copy_range for a node is found, there is no need to traverse its children.

Once the algorithm is finished (making sure that, after the last node is processed and there is a candidate, this is also added to the copy_range_map), candidate_copy_ranges contains a mapping from source buffer ranges that can be copied to recreate the target buffer. Any gaps between successive target ranges require to be filled with data from the original target buffer. Therefore, the difference data to recreate the target buffer from the source buffer consists of an ordered list of instructions that are each either:
- COPY(start_bit_position;number_of_bits_to_copy): a copy operation that consists of the start bit position in source buffer and the number of bits to copy
- INSERT(bit_buffer): an insert operation that consists of a bit buffer that must be inserted

This ordered list forms part or all of the difference data that can be sent to the client 2.

The table below shows how the algorithm operates when encoding the exemplary source and target data shown in Figures 4 and 5:

| Target buffer | Target tree | Source tree | Candidate copy operations | Operation added to difference data | Notes |
|---|---|---|---|---|---|
| Bit position | Current node | Matching nodes | | | |
| 0 | - | - | - | | #1 |
| 0 | a | - | - | | #2 |
| 0 | b | 2 | [0,132]₂ | | #3 |
| 133 | 9 | - | - | COPY(0;133) | #4 |
| 133 | h | 8, 9, 10 | [133,142]₈, [143,152]₉, [153,162]₁₀ | | #5 |
| 133 | i | 8, 9, 10 | [133,152]₈₋₉, [143,162]₉₋₁₀ | | #6 |
| 133 | j | 11 | [143,172]₉₋₁₁ | | #7 |
| 163 | k | - | - | COPY(143;30) | #8 |
| 163 | l | - | - | | #9 |
| 163 | m | - | - | | #10 |
| 163 | n | 14 | [173, 227]₁₄ | INSERT(target_buffer[163..172]) | #11 |
| 173 | o | - | - | COPY(173;55) | #12 |
| 228 | p | 16 | [292,311]₁₆ | INSERT(target_buffer[228..293]) | #13 |
| 294 | | | | COPY(294;4) | #14 |

| | | | | | |
|---|---|---|---|---|---|
| Notes #1 Before traversing the target tree, *target_buffer_bit_position* is initialized to 0. This value corresponds to the current bit position when using the difference data to recreate the target buffer. Keeping track of this value also determines the bit buffer range to use for insert operations. #2 There is no match for node a in source and there are no bits that need to be inserted. #3 Node b can be matched to node 2 in source, so the bit range covered by node 2 becomes a candidate copy operation, which is denoted as [*first_bit_position, last_bit_position*]_{source nodes in range}. Note that the source nodes are not needed to create the final copy operation in the difference data but are there for clarification purposes only. Copy operations remain as candidates as they may be extended when the next node in the target matches the next node in the source. Node b is fully matched, recursion stops here and the algorithm continues with the parent/next sibling of b. #4 There is no match for node g in source, so the candidate copy operation cannot be extended. The candidate copy operation is now added to the difference data. The list of candidate copy operations is emptied and *target_buffer_bit_position* is updated to *first_bit_position*_{g}*.* #5 Node h can be matched to nodes 8, 9 and 10 in source which are all selected as candidate copy operations. #6 Node i can again be matched to source nodes 8, 9 and 10. As there are candidate copy operations, determine which of these source nodes can be extended. For this, the following rule is enforced: *first_bit_position*_{matched source node}== *last_bit_position*_{candidate copy range} + 1 Node 8: *first_bit_position=*133 which does not match the *last_bit_position+*1 of any of the candidate copy ranges Node 9: *first_bit_position=*143 which matches *last_bit_position+*1of [133,142]s, so update candidate copy range to [133,152]₈₋₉ Node 10: *first_bit_position=*153 which matches *last_bit_position+*1 of [143,152]₉, so update candidate copy range to [143,162]₉₋₁₀ #7 Node j matches source node 11 and extends candidate copy range [143,162]₉₋₁₀ #8 There are no matching source nodes, so the candidate copy range cannot be extended and is ready to be added to the difference data. Candidate copy operations list is emptied and the target buffer bit position is updated to *first_bit_positionₖ.* #9 There are no matches for target node i, so proceed with next node #10 There are no matches for target node m, so proceed with next node #11 Node n matches source node 14, so create a candidate copy range. As *first_bit_position*ₙ !*= target_buffer_bit_position,* this means that bit range [*target_buffer_bit_position, first_bit_position*ₙ*-*1] cannot be copied from the source buffer but must be inserted instead. So an insert operation is added to the difference data and the *target_buffer_bit_position* is updated to *first_bit_position*ₙ*.* #12 There are no matching nodes, so add the candidate copy operation to the difference data and update *target_buffer_bit_position.* #13 Node p matches source node 16, so create candidate copy range. As *first_bit_positionₒ* !*= target_buffer_bit_position,* add insert operation to difference data and update *target_buffer_bit_position.* #14 Traversal of target tree is done. What remains is writing the final operation to the difference data, which in this case is the candidate copy operation | | | | | |

This process results in difference data which may be sent to clients as an efficient map update, optionally along with further difference data corresponding to further layers of NDS.Live map data.

### Optimizing the difference data

In order to further reduce the amount of data required to update the source to the target buffer, difference-data files may be encoded efficiently before being transmitted from the map server 1. For example, run-length encoding may be applied to the difference data.

In some embodiments, copy operations in the difference data are compressed by-instead of storing each bit position and number of bits as full 32 integers-using varint (variable integer) encoding and array delta encoding. This may also be done for encoding the length of the insert buffers in the insert instructions.

In some embodiments, the following schema may be used to encode the difference data:
1 Insert Operation format:
2 "COPY" : bit[1] = '0'
3 first_bit_position : varint (delta encoded)
4 bit_buffer_length : varuint
5
6 "INSERT" : bit[1] = '1'
7 bit_buffer_length : varuint
8 bit _buffer : bits[bit_buffer_length]

A custom length var(u)int encoding algorithm may be used to enable partitioning of the encoded value at arbitrary lengths. Using shorter lengths (instead of the traditional 8-bits used for varint encoding) has been determined to lead to an additional 1-2% size reduction of the difference data in some use cases.

### Experimental validation

The approach described above has been tested on actual NDS.Live data and been determined to enable highly compressed difference data to be generated from serialized map data. The compression has been found to be especially effective on certain types of data such as lane geometry data (e.g. a Road Geometry Layer).

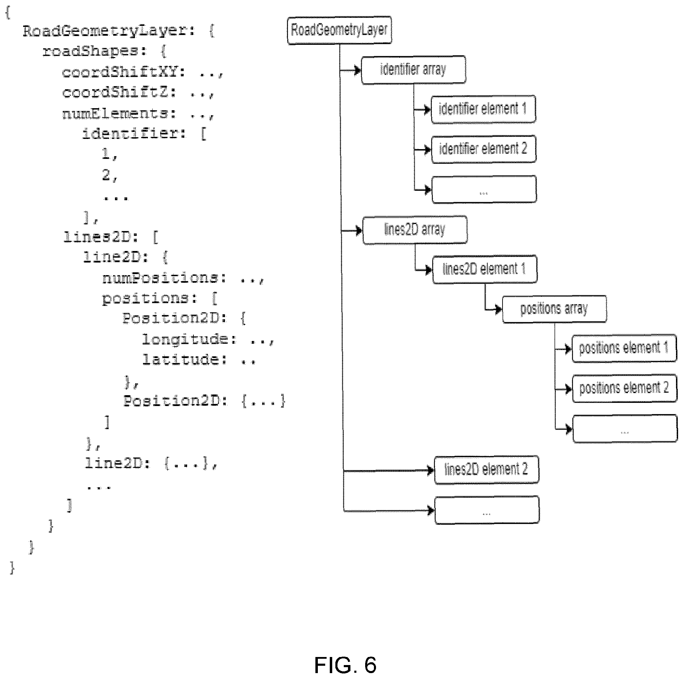

In order to assess the efficiency of the algorithm, hierarchical trees for the data structures stored in NDS.Live were created. The default unit of data transmitted was the SmartLayerTile which itself consists of one or more DataLayers. The SmartLayerTile's SmartLayerHeader contains packaging details for each DataLayer which allows for specifying differential encoding details. To create the hierarchical tree for a DataLayer, the zserio serializer was modified to generate a node in the tree for every array element encountered in one of the contained data structures. For example, Figure 6 shows, on the right side of the figure, an example of a tree structure created when serializing the RoadGeometryLayer data shown on the left side of the figure.

This approach does not address every field in the zserio data structure (e.g., the coordShiftXY and coordShiftZ fields do not add a node in the tree) and hence the resulting tree may have gaps. To meet the required properties of the tree to use in the compression algorithm above (i.e. having complete contiguous bit sequence coverage) these gaps are filled with "filler nodes" that are included within the tree.

It has been observed that the copy ranges found using the above approach can often be extended significantly to both sides resulting in even better compression performance. This may be a consequence of the gap filling. A post-processing step may be implemented to exploit this by extending copy ranges where possible.

To test the performance of the algorithm, various maps were converted into NDS.Live tiles and where differentially compressed using a conventional byte-aligned differential compression and also using a method according to the present disclosure. Significant additional compression was found to be possible using the novel method. In particular, the new algorithm significantly reduced the size of the SmartLayerTiles, consistently reducing the size of updating the map to an order of magnitude less (ratio of -90%) compared with not using any differential compression, and reducing the update size achievable using standard differential-compression algorithms by a factor of three.

In some embodiments, a hybrid approach may be used where multiple differential compression algorithms, including an algorithm according to the present disclosure as well as one or more conventional algorithms, are used to create difference-data files and the best one is selected for any given portion of map data, optionally also checking whether applying regular compression (e.g. ZLIB, ZSTD, Brotli or LZ4) additionally reduces the data. However, this may lead to additional complexity both on the server and client side which may not be worthwhile. Other embodiments may just use an approach as disclosed herein for compressing all map data.

In summary, methods disclosed herein can significantly reduce the amount of data needed to be sent in order to update map tiles stored in a vehicle's cache. By using metadata about the structure and contents of the map data stored in a tile, methods disclosed herein can apply differential compression more efficiently than approaches such as bsdiff, vcdiff and fossil, even when the map data has been serialized. When applied to NDS.Live map tiles, at least some embodiments result in a delta encoding that is, on average, 50% of the size of other approaches.

For delivery of NDS.Live map tiles, in which the data is bit-aligned, inserting one new value in an array can result in the subsequent contents of that array shifting by only a few bits thus causing all of the data at the byte level to appear as changed if using a compression algorithm such as bsdiff. Instead, embodiments may make use of metadata, e.g. extracted during the creation of the NDS.Live tiles, to build two lookup trees where each node contains data ranges that are likely to appear in both source and target. Embodiments may then use tree matching to create the difference data comprising copy and insert operations. As the node ranges are encoded as bit positions in the source, the algorithm performs well on NDS.Live tiles and also on other bit-aligned data.

It will be appreciated by those skilled in the art that the disclosure has been illustrated by describing one or more specific embodiments thereof, but is not limited to these embodiments; many variations and modifications are possible.

## Claims

1. A method of differentially compressing structured map data to generate difference data for regenerating a target-map bitstream from a source-map bitstream, wherein the source-map bitstream encodes structured source map data that comprises a structure of source data entities, and wherein the target-map bitstream encodes structured target map data that comprises a structure of target data entities, the method comprising:
using the structure of the source data entities within the source map data to determine a set of source bit sequences present within the source-map bitstream, wherein each of the source bit sequences of the set encodes one or more of the source data entities;
using the structure of the target data entities within the target map data to determine a set of target bit sequences present within the target-map bitstream, wherein each of the target bit sequences of the set encodes one or more of the target data entities, and to determine an associated structure of the set of target bit sequences;
using the structure of the set of target bit sequences to identify a first bit sequence in the set of target bit sequences that is also present within the set of source bit sequences; and
generating difference data comprising insert instructions and copy instructions for regenerating the target-map bitstream from the source-map bitstream, wherein the copy instructions include a copy instruction for copying at least the first bit sequence from the source-map bitstream when regenerating the target-map bitstream.

2. The method of claim 1, wherein the identified first bit sequence is a longest bit sequence that is present within both sets of bit sequences, and wherein said copy instruction instructs copying exactly the identified first bit sequence from the source-map bitstream when regenerating the target-map bitstream.

3. The method of claim 1, further comprising:
using the structure of the set of target bit sequences to identify a second bit sequence in the set of target bit sequences that is also present within the set of source bit sequences;
determining that the second bit sequence is contiguous with the first bit sequence in the source-map bitstream; and
generating the difference data such that said copy instruction instructs copying a bit sequence that is or comprises a concatenation of the first bit sequence and the second bit sequence.

4. The method of any preceding claim, further comprising:
calculating hashes of all of the source bit sequences;
storing the hashes in an electronic memory as a searchable set of source hashes;
calculating hashes of some or all of the target bit sequences; and
identifying a bit sequence in the set of target bit sequences as also being present within the set of source bit sequences by calculating or retrieving a hash of the bit sequence and searching the set of source hashes for the hash of the bit sequence.

5. The method of any preceding claim, wherein:
the structure of the data entities within the source map data comprises a hierarchy of the data entities;
the structure of the data entities within the target map data comprises a hierarchy of the data entities;
the structure of the set of target bit sequences present within the target-map bitstream comprises a hierarchy of target bit sequences, wherein each child sequence in the hierarchy of target bit sequences has a parent sequence of which the child sequence is a subsequence; and
the method comprises traversing the hierarchy of target bit sequences to identify one or more bit sequences in the hierarchy of target bit sequences that are also present within the set of source bit sequences.

6. The method of claim 5, comprising representing the hierarchy of target bit sequences by a tree of nodes in an electronic memory, wherein each node comprises data encoding a first bit position and a length or last bit position of a respective target bit sequence, and wherein traversing the hierarchy of target bit sequences comprises traversing the tree of nodes.

7. The method of claim 5 or 6, wherein the source-map bitstream is a root of a hierarchy of source bit sequences, and wherein the target-map bitstream is a root of the hierarchy of target bit sequences.

8. The method of any of claims 5 to 7, wherein traversing the hierarchy of target bit sequences comprises performing a depth-first traversal wherein, for each branch that is descended, the descending ceases if a bit sequence represented by a child node on the branch is identified as being also present within the set of source bit sequences.

9. The method of any of claims 5 to 8, wherein the data entities within the source map data and the target map data comprise primitives, objects and arrays, and wherein each hierarchy of data entities is determined at least partly based upon array membership, whereby a data entity that is a member of an array is a child of the data entity that is the array.

10. The method of any of claims 5 to 9, wherein the hierarchy of target bit sequences comprises at least two levels of subsequences below a root level.

11. The method of any preceding claim, wherein at least one of the source bit sequences is not byte-aligned within the source-map bitstream data, or at least one of the target bit sequences is not byte-aligned within the target-map bitstream data.

12. The method of any preceding claim, wherein each of the copy instructions in the difference data comprises a bit position and a bit length, wherein the bit positions are delta encoded, and wherein the bit positions and bit lengths are encoded as variable-width integers.

13. The method of any preceding claim, wherein the source and target map data are NDS.Live map data, and wherein the source-map and target-map bitstreams are serialized NDS.Live map data.

14. Computer software comprising instructions which, when executed on a processing system, cause the processing system to perform the method of any preceding claim.

15. A processing system configured to perform the method of any one of claims 1 to 13.
